(19) **Europäisches Patentamt**

**European Patent Office**

**Office européen des brevets**

(11) **EP 0 704 978 B1**

(12) **EUROPEAN PATENT SPECIFICATION**

(45) Date of publication and mention
of the grant of the patent:
**18.06.2003 Bulletin 2003/25**

(51) Int Cl.[7]: **H03M 1/06**, H03M 3/02,
H03M 7/02

(21) Application number: **95306951.5**

(22) Date of filing: **29.09.1995**

(54) **Selection device for selecting electric cells and apparatus using the same**

Auswahlvorrichtung zur Wahl elektrischer Zellen und Gerät zur Anwendung einer solchen Vorrichtung

Dispositif de sélection pour la sélection de cellules électriques et appareil utilisant ce dispositif

(84) Designated Contracting States:
**DE GB**

(30) Priority: **30.09.1994 JP 26128194**

(43) Date of publication of application:
**03.04.1996 Bulletin 1996/14**

(73) Proprietor: **KABUSHIKI KAISHA TOSHIBA**
**Kawasaki-shi, Kanagawa 212-8572 (JP)**

(72) Inventor: **Yasuda, Akira,**
**c/o Intellectual Property Div.**
**Minato-ku, Tokyo 105 (JP)**

(74) Representative: **Freed, Arthur Woolf**
**MARKS & CLERK,**
**57-60 Lincoln's Inn Fields**
**London WC2A 3LS (GB)**

(56) References cited:
**EP-A- 0 322 965**      **EP-A- 0 482 845**
**CA-A- 2 095 156**

- **ELECTRONIC DESIGN, vol. 34, no. 30, December 1986 HASBROUCK HEIGHTS, NEW JERSEY US, page 28 GOODENOUGH 'PROMs ensure monotonicity for 16-bit DAC'**
- **REDMAN-WHITE ET AL: 'Integrated fourth-order sigma-delta-convertor with stable self-tuning continuous-time noise shaper' IEE PROCEEDINGS-G CIRCUITS, DEVICES AND SYSTEMS vol. 141, no. 3, June 1994, STEVENAGE, GB, pages 145 - 150**

EP 0 704 978 B1

**Description**

This invention relates to a selection device, and more particularly to a selection device that selects, for example, the outputs of electric cells in a D/A converter, and to various apparatuses using the selection device.

with a conventional digital/analog converter, Din (an integer) unit current cells are selected to produce a current output corresponding to the input digital signal Din. Selecting unit current cells an output current of Io = Icell x Din is produced, whereby digital/analog conversion is effected.

In general, current cells have errors due to variations. If an error in each current cell is $\varepsilon_i$, the error contained in Io will be expressed by the following equation (1):

$$\sum_{i=0}^{Din} \varepsilon_i \qquad\qquad (1)$$

Therefore, a differential linear error DNL has the value expressed by equation (2), so that the conversion accuracy is determined with process variations such as variations of manufacturing processes and manufacturing machines being reflected directly in the D/A conversion error:

$$DNL = \varepsilon_i \qquad\qquad (2)$$

To perform high-accuracy conversion, this scheme either uses an expensive high-accuracy process or requires adjustment such as trimming, resulting in higher cost.

A method that has improved this disadvantage is a dynamic element matching method.

In this method, if the conversion time is Ts and the number of bits is $n_{DA}$, the current cell used will be changed at intervals of $Ts/2^{n_{DA}}$ so that all of the cells may be used equally in each conversion. By doing this, the output charge Qout is expressed by the following equation (3) :

$$Qout = \sum_{i=1}^{2^{n_{DA}}} Ii \frac{Ts}{2^{n_{DA}}} Din$$

$$= \frac{Ts}{2^{n_{DA}}} Din Io \sum_{i=1}^{2^{n_{DA}}} (1+\varepsilon_i) = I_{av} Ts Din \qquad (3)$$

where Ii is the output current of the ith cell expressed as:

$$\frac{1}{2^{n_{DA}}} \sum_{i=1}^{2^{n_{DA}}} (1+\varepsilon_i) = 1$$

and Iav is a constant expressed as:

$$I_{av} = \frac{Ts}{2^{n_{DA}}} \sum_{i=1}^{2^{n_{DA}}} (1+\varepsilon_i) = 1$$

Because of this, an error in each current cell has an effect only on the gain error. This makes it possible to achieve high conversion accuracy even when there are variations in the cells. Namely, an error in each cell is averaged with respect to time, thereby improving the accuracy.

With the dynamic element matching method, however, each cell must be selected in $1/2^{n_{DA}}$ of the conversion time, so that the elements are required to operate at high speeds.

As described above, the conventional scheme has the disadvantage that the performance deteriorates significantly due to variations in the elements, such as variations in the current cells. In the case of the dynamic element matching method, the current cells must be changed at a high speed, making it difficult to achieve a high-speed conversion operation.

Further, a dynamic element matching method using an individual level averaging is known from CA-A-2 095 156.

The object of the present invention is to provide a selection device capable of not only reducing errors by making the operation speed lower, but also decreasing errors at a specific frequency.

The present invention provides a selection device comprising selector means for selecting selectable objects in accordance with an input signal level, that said selection device includes integrating means ($14_1$, $14_2$) for integrating, one or more times, data representing a state in which each of selectable objects ($22_1...22_n$) having a relative error between them is used during a predetermined period; and said selector means (13) includes comparing means (19) for comparing a signal corresponding to an integration result of the integrating means with a previous signal corresponding to a previous integration result to output a comparison result representing the number of times the selectable objects are used; and selection means (20) for selecting the selectable objects in an order in which the number of times the selectable objects are used during the predetermined period descends in accordance with the comparison result.

With the present invention, the effect of errors at an arbitrary frequency can be reduced, improving the accuracy remarkably. Because element accuracy need not be high, no high-accuracy elements are required, enabling cost reduction.

This invention can be more fully understood from the following detailed description when taken in conjunction with the accompanying drawings, in which:

FIG. 1 is a block diagram of a selection device according to a first embodiment of the present invention;
FIG. 2 is a block diagram of the selector shown in FIG. 1;
FIG. 3 is a circuit diagram of current cells connected to the selection device of FIG. 1;
FIG. 4 is a circuit diagram of a capacitor array circuit;
FIG. 5 is a block diagram of a selection device according to a second embodiment of the present invention;
FIG. 6 shows a format for a select signal;
FIG. 7 is an equivalent circuit in connection with errors in the second embodiment;
FIG. 8 shows the simulation result related to errors in the second embodiment;
FIG. 9 is a block diagram of a selection device according to a third embodiment of the present invention;
FIG. 10 is a block diagram of a selection device according to a fourth embodiment of the present invention;
FIG. 11 is a block diagram of a selection device according to a fifth embodiment of the present invention;
Fig. 12 is a block diagram of a selection device according to an example useful for understanding the present invention;
Fig. 13 is a block diagram of a selection device useful for understanding the present invention;
Fig. 14 shows the simulation result related to errors in the selection device of Figure 13;
Fig. 15 is a block diagram of a transmitter using a selection device of the invention;
Fig. 16 is a block diagram of a selection device according to a seventh embodiment of the present invention;
Fig. 17 is a block diagram of a selection device according to an eighth embodiment of the present invention;
Fig. 18 is a block diagram of a selection device according to an example useful for understanding the present invention;
Fig. 19 is a block diagram of a selection device according to a ninth embodiment of the present invention;
Fig. 20 is a block diagram of a selection device according to a tenth embodiment of the present invention;
Fig. 21 is a block diagram of a selection device according to an example useful for understanding the present invention;
Fig. 22 is a block diagram of a selection device according to an eleventh embodiment of the present invention;
Fig. 23 is a block diagram of a selection device according to a twelfth embodiment of the present invention;
Fig. 24 is a block diagram of a selection device according to a thirteenth embodiment of the present invention;
FIG. 25 is a block diagram of a selection device according to a fourteenth embodiment of the present invention;
FIG. 26 is a block diagram of a selection device according to a fifteenth embodiment of the present invention;
FIG. 27 is a block diagram of a receiver using a D/A converter with a selection device of the present invention.
FIG. 28 is a block diagram of a transmitter using a D/A converter with a selection device of the present invention.
FIG. 29 is a block diagram of a transmitter using a D/A converter with a selection device of the present invention;
FIG. 30 is a circuit diagram of the quadrature modulator used in the transmitter of FIG. 29; and
FIG. 31 is a circuit diagram of a clock generator for generating a clock signal to be supplied to the quadrature modulator.

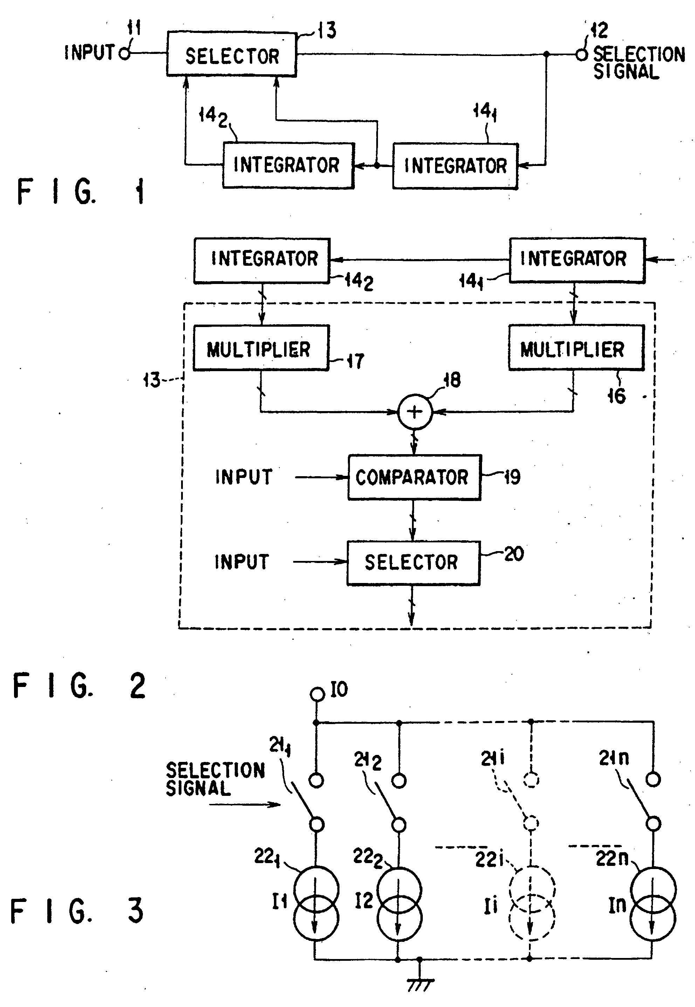

FIG. 1 is a block diagram of a selecting circuit according to a first embodiment of the present invention. FIG. 2 shows the selector in the selection device of FIG. 1. The selection device of FIG. 1 is connected to current cells as shown in FIG. 3.

As shown in FIG. 1, the selection device comprises a selector 13 connected between an input terminal 11 and an output terminal 12, two stages of integrators connected to the output terminal of the selector 13, that is, first and second integrators $14_1$ and $14_2$. The output terminals of the two stages of integrators $14_1$ and $14_2$ are connected to the control terminals of the selector 13. The selector 13, according to the input, selects the linear sum of the output of the first integrator $14_1$ and that of the second integrator $14_2$ in ascending order and then outputs a select signal. The select signal is a signal used for selecting objects from selectable objects, i.e., electric cells such as current cells or voltage cell by the number corresponding to the input signal. The integrators $14_1$ and $14_2$ integrate the select signal.

Specifically, as shown in FIG. 2, the output terminals of the integrators $14_1$ and $14_2$ are connected to the multipliers 16 and 17 of the selector 13, respectively. These multipliers multiply the integral outputs of the integrators $14_1$ and $14_2$ by specific coefficients. The outputs of the multipliers 16 and 17 are added at an adder 18. The addition outputs are compared at a comparator 19 according to the input to determine the large or small relation between them. A selector 20 selects the addition output of the smaller value obtained at the comparator 19 and outputs it as a select signal.

The select signal from the selector 20 in the selector 13 selectively opens and closes the switches $21_l$ to $21_n$ of a current cell circuit shown in FIG. 3, thereby selectively connecting the current cells $22_l$ to $22_n$.

In other words, when the selector 13 receives a digital input signal, it outputs a select signal in accordance with a value of the digital input signal. The digital input signal has a value of one level of an analog signal, the selector 13 outputs a select signal for selecting a single current cell. For example, the switch $21_1$ is selected and closed by the select signal, so that the output current from the current cell $22_1$ corresponding to the selected switch $21_1$ is output as an output current Io. If the digital input signal has a value of two levels of an analog signal, the select signal of 110000... 0 for selecting the switches $21_1$ and $21_2$, for example is output from the selector 13. As a result, the currents from the current cells $22_1$ and $22_2$ are added and output as the output signal Io. In such a manner, the currents of the current cells $21_l$ to $21_n$ are selectively added in accordance with the value of the digital input signal to form an output current Io. In other words, the digital signal is converted to an analog signal.

The select signal output from the selector 13 is input to the integrator $14_1$ and integrated thereby. The integration signal is input to the next stage integrator $14_2$ to be further integrated. The integration signals from the integrators $14_1$ and $14_2$ are supplied to the multipliers 16 and 17 of the selector 13, respectively. The result signals of the multipliers 16 and 17 are added by an adder 18. The addition signal is compared with a previous signal in accordance with the input signal by a comparator 19, so that the magnitude relationship between the addition signals is detected. Since the addition signal indicates a value corresponding to the used times of each of the current cells during a predetermined time period, the used times of the current cells during a predetermined period can be compared with one another on the basis of the magnitude relationship between the addition signals. The selector 20 outputs a select signal for selecting the current cells in a descending order of the used times during a predetermined period, in accordance with the comparison result. In other words, the selector 13 outputs a select signal so that the current cells $21_l$ to $21_n$ having characteristic variations are equally used during a predetermined period.

This enables errors in the output of all of the current cells to be decreased even if each current cell has an error. Unlike the conventional dynamic element matching method, it is not necessary to select each cell in $1/2^{nDA}$ of the conversion time, and consequently the elements are not required to operated at high speeds.

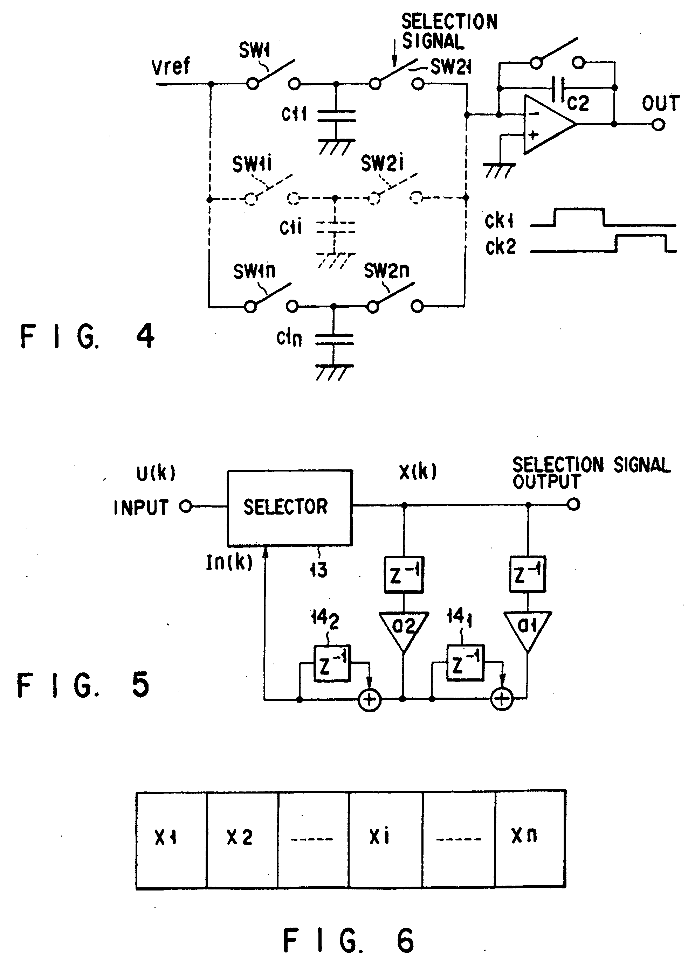

While in the embodiment, the current cells are used as the objects to be selected, the present invention may be applied to a device that adds values having errors to produce an output. For instance, the invention may be applied to a capacitor array as shown in FIG. 4. In this example, clock ckl closes switches $sw1_l$ to $sw1_n$, thereby charging capacitors $cl_1$ to $cl_n$. Clock ck2 closes the selected switch, for example, switch $sw2_1$, thereby connecting the selected capacitor $cl_1$ to the output side, with the result that the charge corresponding to capacitor c2 is transferred to the output. With a D/A converter that uses a selection device of the present invention which is shown in FIGS. 1 and 2 to select those capacitors $c1_l$ to $c1_n$, even if the capacitors have errors, the effect of the errors can be reduced.

Referring to FIG. 5, a concrete example of a selection device according to the present invention will be explained as a second embodiment. In this embodiment, integrators $14_1$ and $14_2$ are composed of delay elements indicated by $z^{-1}$ and adders. The output of the integrator $14_2$ is inputted to a selector 13.

A select signal, the output of the selector 13, is made up of a plurality of signals as shown in FIG. 6. Each signal can take the value of 0 or 1. If the signal is 1, the corresponding current cell will be selected, whereas if the signal is 0, it will not be selected. It is assumed that the integrators $14_1$ and $14_2$ integrate the individual signal in the select signal. Therefore, it can be considered that a plurality of integrators are connected in parallel.

Here, the current Ii in the current cells shown in FIG. 3 is expressed by the following equations (4) and (5):

$$I_i = I_{av}(1+\varepsilon_i) \tag{4}$$

$$I_{av} = \frac{1}{n} \sum_{i=1}^{n} I_i \tag{5}$$

A vector indicating the select signal at time k is expressed by the following equation (6):

$$X(k) = [x_1(k), x_2(k) \cdots x_i(k) \cdots x_n(k)]^T \tag{6}$$

It is assumed that the input signal is U(k) and U(k) is an integer taking the value ranging from 0 to n.

The selector 13 operates in such a manner that it brings as many select signals as correspond to the input into the 1 state, in ascending order of the value of the outputs In(k) of the integrators $14_1$ and $14_2$.

X(k) indicates the current cell to be selected. The current output Iout is determined by the following equations (7) and (8):

$$I_{out}(k) = <C, X(k)> \tag{7}$$

$$C = [I_{av}(1+\varepsilon_1) \; I_{av}(1+\varepsilon_2)$$

$$\cdots I_{av}(1+\varepsilon_i) \cdots I_{av}(1+\varepsilon_n)] \tag{8}$$

where $<\cdot, \cdot>$ indicates the inner product of a vector.

Here, X is a vector representing the selection of a cell as described above. As shown in equation (7), the current actually outputted contains error Iouterr, which can be expressed by the following equations (9) and (10):

$$I_{outerr}(k) = <C_{err}, X(k)> \tag{9}$$

$$C_{err} = [I_{av}\varepsilon_1, I_{av}\varepsilon_2 \cdots I_{av}\varepsilon_i \cdots I_{av}\varepsilon_n] \tag{10}$$

Therefore, X(k) is used to determine the error contained in the output. From equation (4) and equation (5), the following equation (11) is obtained:

$$\sum_{i=1}^{n} \varepsilon_i = 0 \tag{11}$$

That the selector 13 operates in such a manner that it brings as many select signals as correspond to the input into the 1 state, in ascending order of the values of the outputs In(k) of the integrators $14_1$ and $14_2$ is equivalent to selecting a vector X(k) closest to the opposite vector to In(k) vector by using as many factors as the number of inputs.

The error vector at that time is expressed by the following equation (12):

$$Q(k) = In(k) + X(k) [q_1(k), q_2(k) \cdots qi(k) \cdots q_n(k)] \tag{12}$$

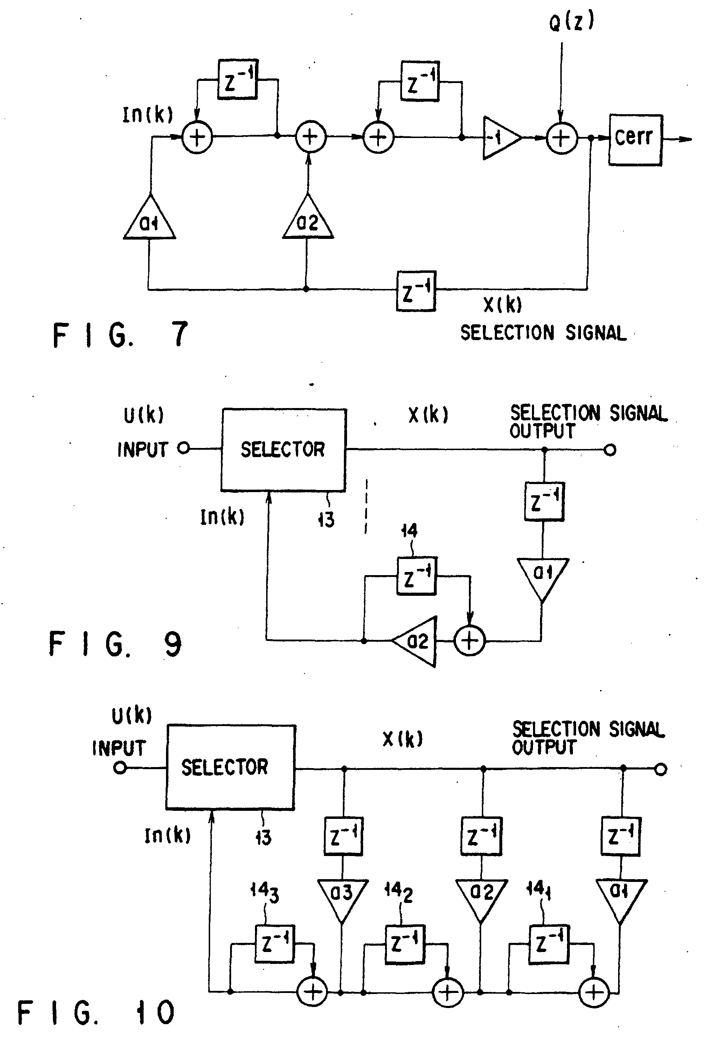

In this case, if conversion is represented as Q(z), an equivalent circuit for errors in the present embodiment can be expressed as shown in FIG. 7. With the equivalent circuit, a transfer function from error Q to X is given by the following equation (13):

$$X(z) = \frac{(1-z^{-1})^2}{(1-\alpha_2) z^{-2} + (-2+\alpha_1+\alpha_2) z^{-1} + 1} \, Q(z) \tag{13}$$

If *1 = 1 and *2 = 1, the following equation (14) will hold:

$$X(z) = (1-z^{-1})^2 Q(z) \tag{14}$$

In equation (14), Q(z) is multiplied by a noise shaping term $(1 - z - 1)^2$, from which it is understood that Q(z) undergoes second-order shaping. The simulation result of error signals in the output is shown in FIG. 8. From the figure, errors are suppressed in lower-frequency regions.

As for the actual output, the output Io shown in FIG. 3 may be a current output, or the current output may undergo current-to-voltage conversion to produce a voltage output.

As described above, use of the present embodiment reduces the effect of an error in each current cell remarkably in the vicinity of DC, making it possible to construct a high-accuracy D/A converter even when there are variations in the elements. Since a high-accuracy process is not needed, it is possible to reduce cost.

A third embodiment of the present invention will be described with reference to FIG. 9. In this embodiment, use of a single integrator 14 simplifies the configuration. Because the noise shaping characteristic is of the first order and gentle, the present embodiment is effective when the over-sampling ratio cannot be made large. The characteristic of a filter placed behind can be made gentle.

Furthermore, the frequency at which shaping suppresses noise can be set using *2. For instance, if *2 = -1, the frequency can be set at half of the sampling frequency.

FIG. 10 shows a fourth embodiment of the present invention. with this embodiment, three integrators $14_1$, $14_2$, and $14_3$ are connected, thereby realizing a third-order shaping characteristic. A higher-order shaping characteristic can reduce noise more in the vicinity of DC, enabling a higher-accuracy conversion.

A transfer function related to error at this time can be expressed by the following equation (15): X(z) =

$$\frac{(1-z^{-1})^3}{(a_3-1)z^{-3}+(-a_2-2a_3+3)z^{-2}+(a_1+a_2+a_3-3)z^{-1}+1} \, Q(z) \tag{15}$$

Generally, with a third-order or higher $\Delta\Sigma$ modulator, when the poles of the transfer function are placed at the origin, the operation becomes unstable. Therefore, the pole must be placed at stable points inside the unit circle.

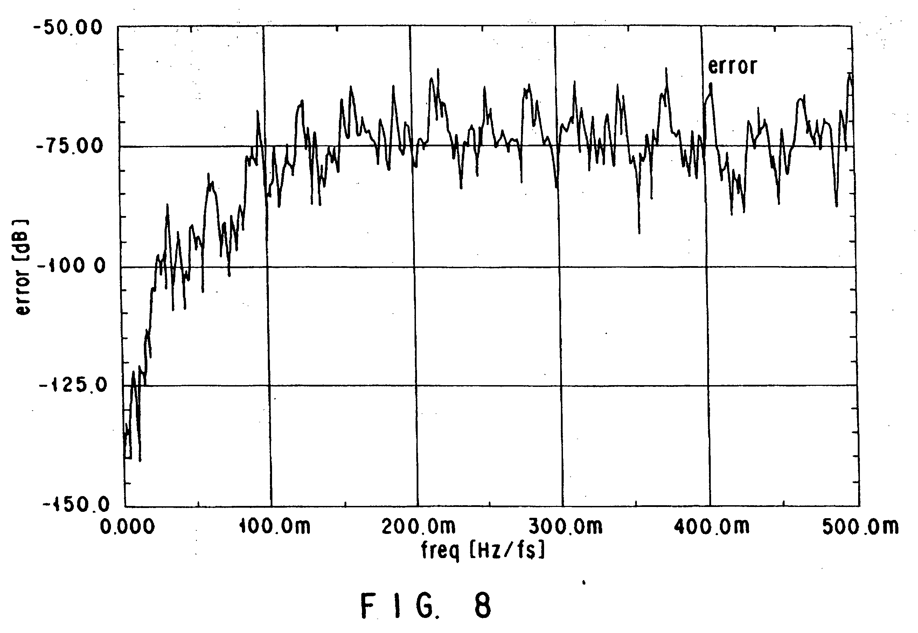

Similarly, a higher-order shaping characteristic can be realized. A fifth embodiment of the nth order according to the present invention is shown in FIG. 11. In the present embodiment, n stages of integrators $14_l$ to $14_n$ are provided. By raising the order, it is possible to improve the accuracy more.

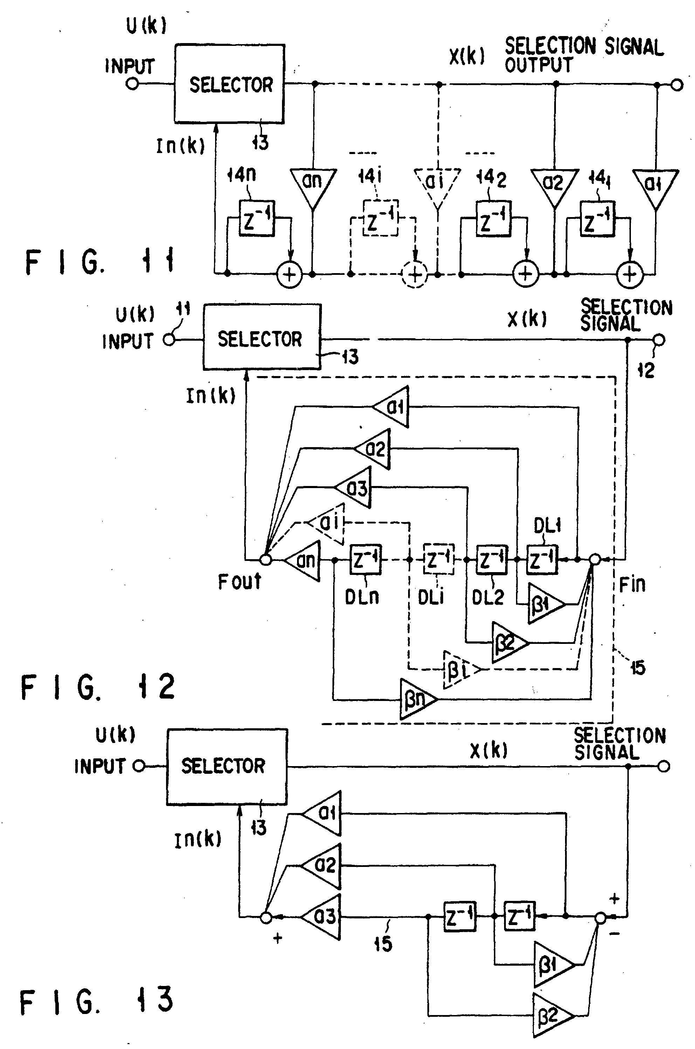

An example useful for understanding the present invention which uses an nth order configuration will be explained with reference to FIG. 12.

In this example, a digital filter 15 is connected between the select signal output terminal 12 and the selector 13. The digital filter 15 comprises a plurality of delay circuits $DL_l$ to $DL_n$ that receive a select signal, a plurality of coefficient multiplier circuits $\alpha$ to $\alpha_n$ connected to said plurality of delay circuits respectively, and to the selector 13, and a plurality of coefficient multiplier circuits $\beta$ to $\beta_n$ connected to the delay circuits $DL_l$ to $DL_n$ respectively, and to the select signal output terminal 12.

With this configuration, it is possible to place the zero points and the poles of the noise transfer characteristic at arbitrary points. Therefore, it is possible to reduce not only errors in the vicinity of DC but also errors at high frequencies. For instance, in the case of the fourth order, to set two zero points at the origin and two zero points at fs/m, if a transfer function for the section indicated by a dotted line from Fin to Fout is F(z) = [z(z)]/[P(z)], $\beta_i$ will be determined using the following equation (16):

$$P(z) = (1-z^{-1})^2 (1-2\cos(\frac{\pi}{m})z^{-1}+z^{-2}) \tag{16}$$

In this case, the pole is set using $\alpha_i$. By using this scheme, it is possible to directly convert a band-pass signal such as ah intermediate frequency signal in the superheterodyne system.

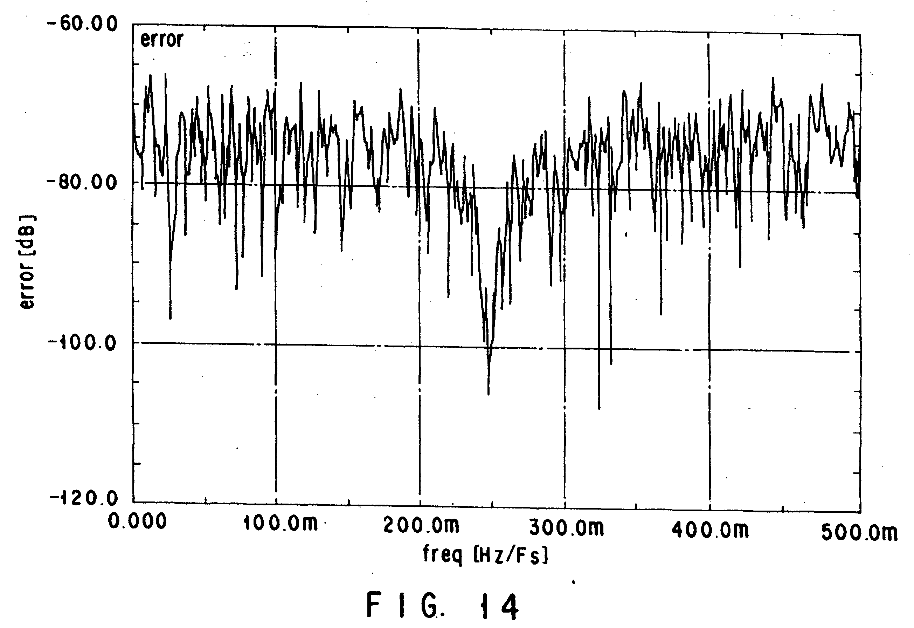

A further example useful for understanding the invention where a zero point is placed at fs/4 in the second order, thereby improving the accuracy at fs/4, is shown in FIG. 13. In this example, the coefficients of the digital filter 15 are as follows: $\alpha_1 = 0$, $\alpha_2 = -1$, $\alpha_3 = 0$, $\beta_1 = 0$, and $\beta_2 = 2$. The simulation result of the frequency characteristic at that time is shown in FIG. 14. From the simulation result, it can be seen that the error components near fs/4 are reduced by noise shaping.

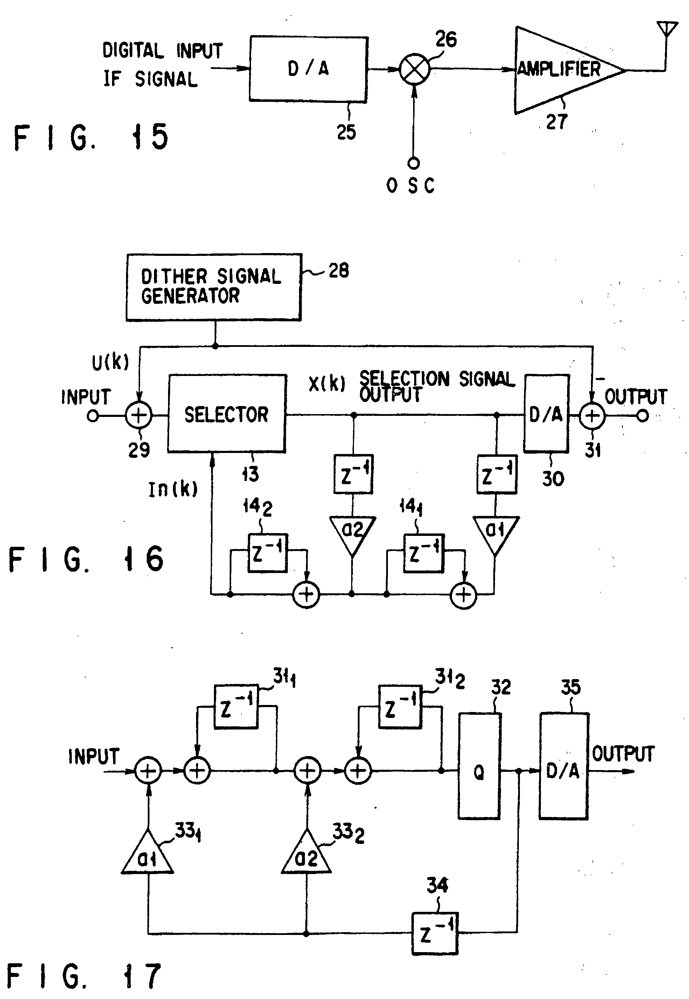

Fig. 15 shows a transmitter using a selection device in accordance with an embodiment of the present invention. With this embodiment, the inputted diqital signal is converted by a D/A converter 25 using the present invention into an analog signal, the unnecessary components of which are attenuated by a filter 26. The resulting signal is then frequency-converted and thereafter amplified at an amplifier 27, which supplies the output.

Here, the inputted digital signal is an IF signal that has undergone the necessary modulation. This makes it unnecessary to use a high-accuracy analog modulator. The D/A converter 25 using a selection device of the invention realizes high-accuracy digital/analog conversion, thereby providing a high-accuracy IF signal. As a result, it is possible to construct a high-accuracy transmitter easily.

With a low intermediate frequency, by directly digitally modulating the carrier-frequency signal, the frequency converter can be eliminated.

A seventh embodiment where a dither signal is applied to the present invention will be explained with reference to FIG. 16.

In the above embodiments, when a DC signal is supplied to the input, the selection of current cells becomes periodic, leading to the disadvantage that noise components concentrate on a specific frequency.

With the present embodiment, a dither signal from a dither signal generator 28 is added to the input signal at an adder 29, thereby changing the input even when a DC input arrives to reduce the concentration of noise components. The added dither signal passes through a D/A converter 30 and is subtracted at an adder 31 on the output side, which removes the added dither signal. when the output signal is connected to a low-pass filter to produce the final output, use of a dither signal whose frequency is higher than the cut-off frequency of the low-pass filter enables the dither signal to be removed.

An eighth embodiment where the present invention is applied to an internal D/A converter in a $\Delta\Sigma$ modulation D/A converter will be explained with reference to FIG. 17.

In the present embodiment, a feedback made up of integrators $31_1$ and $31_2$, a quantizer 32, coefficient multipliers $33_1$ and $33_2$, and a delay circuit 34, is connected to a D/A converter 35. The D/A converter 35 is provided with a selection device of the invention.

In many cases, a 1-bit D/A converter, which generates no relative error theoretically, is used as the internal D/A converter in the $\Delta\Sigma$ modulation D/A converter. In this case, use of a D/A converter using a selection device of the invention can reduce not only relative error but also absolute error. As described above, in general, the reference voltage or current generated contain errors. When the errors are distributed with the true value in the center and the average of them is 0, an error in the absolute error can be reduced.

when multi-bit converters are used as an internal A/D and D/A converters in the $\Delta\Sigma$ modulation D/A converter, making the data length of A/D and D/A 1 bit longer enables the S/N ratio to be improved by 6 dB. However, the noise generated at the internal D/A converter appears directly at the output. When a multi-bit converter was used as an internal D/A converter in a conventional $\Delta\Sigma$ modulation D/A converter, the conversion accuracy of the internal D/A converter was lower than the generally expected conversion accuracy, with the result that the overall conversion accuracy was determined by the accuracy of the internal D/A converter and consequently a high conversion accuracy could not be realized. Furthermore, to realize a high conversion accuracy, trimming was needed, leading to a rise in the cost.

When a D/A converter using a selection device of the invention is used as the internal D/A converter in the $\Delta\Sigma$ modulation D/A converter, the effect of the accuracy of the elements (e.g., current cells) constituting the internal D/A converter is reduced remarkably in the vicinity DC. Therefore, use of the present invention makes it possible to improve the overall conversion accuracy even if a process with a low element accuracy is used.

Furthermore, although a third-order or higher $\Delta\Sigma$ modulator is generally unstable in operation, use of multi-bit converters for the internal A/D and D/A converters enables the modulator to operate stably. If the order of the $\Delta\Sigma$ modulator can be raised, the over-sampling ratio can be lowered, making it unnecessary to use high-speed elements. When the modulator is operated at the same over-sampling ratio, much higher-accuracy conversion can be realized.

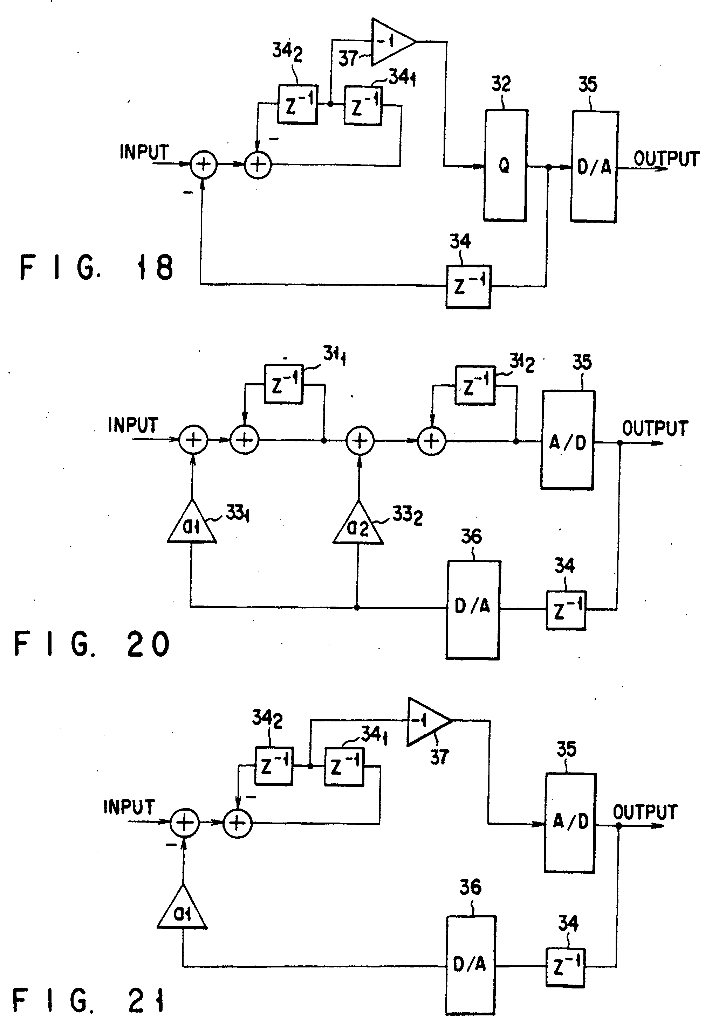

When the $\Delta\Sigma$ modulator and the selection device of the invention are of the band-pass type, a band-pass D/A converter, or a band-pass converter that improves the conversion accuracy at an arbitrary frequency, can be realized. For instance, in an embodiment where a zero point is placed at fs/4 to improve the accuracy at fs/4, a D/A converter using the band-pass selection device shown in FIG. 13 is used as the internal D/A converter in the band-pass $\Delta\Sigma$ modulator shown in FIG. 18.

In Fig. 18, which illustrates an example useful for understanding the invention, the delay signal from the node at which delay circuits $34_1$ and $34_2$ are connected is inverted at an inverter circuit 37. The inverted signal is inputted to a quantizer circuit 32, which quantizes it.

Furthermore, in the embodiment shown in FIG. 17, the input to the selection device, or the input to the internal D/A converter 35, is the output of the ΔΣ modulator. Therefore, even when DC is supplied as an input signal, the input to the selection device is a signal subjected to ΔΣ modulation. Furthermore, use of a multi-bit converter as the D/A converter 35 in the ΔΣ modulator enables the concentration of noise components to be reduced in the modulator. Therefore, although direct input of a DC signal to the selection device of the invention causes the disadvantage that noise components concentrate on a specific frequency, the present embodiment can reduce the effect of noise concentration.

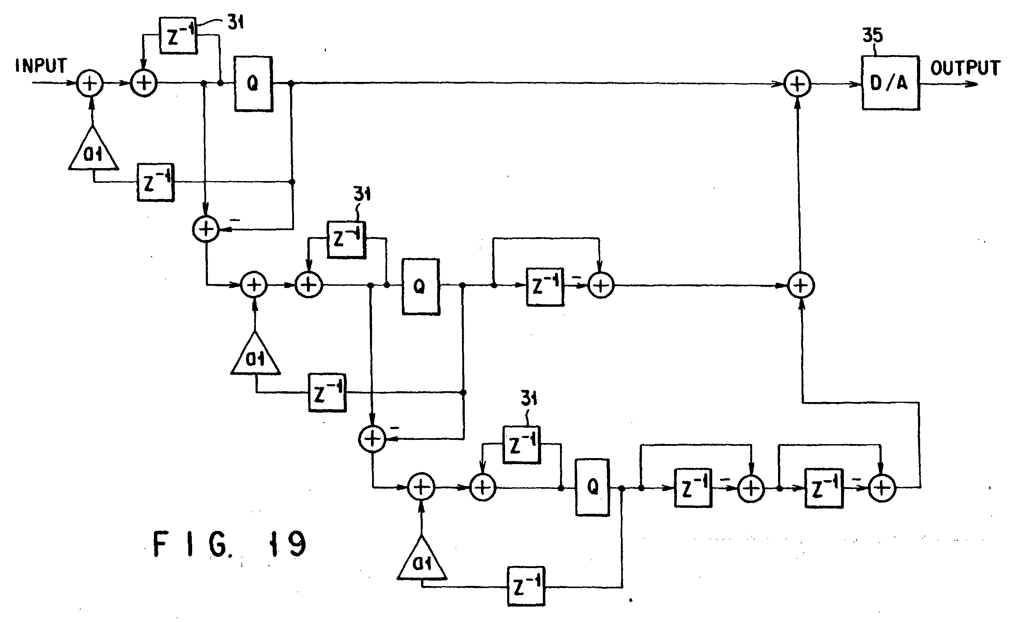

A ninth embodiment where the present invention is applied to an internal D/A converter in a cascade ΔΣ modulation D/A converter 35 will be explained with reference to FIG. 19.

The cascade ΔΣ modulator is a high-order modulator where ΔΣ modulators containing integrators 31 are cascade-connected. A third-order or higher modulator of this type operates stably and is also known as the MASH type modulator.

The MASH type has the disadvantage that even when the output of each ΔΣ modulator is 1 bit, the final output is multiple bits, requiring a multi-bit D/A converter. The overall performance of the modulator is limited by the multi-bit D/A modulator. PWM has been used for a conventional D/A converter. Use of PWM requires a pulse whose duration is a fraction of the D/A conversion time and consequently needs a very high-speed clock frequency. Therefore, to realize a high conversion accuracy, high-speed elements are needed, resulting in higher power consumption.

when a D/A converter using a selection device of the invention is used as the internal converter in the MASH D/A converter, a high-speed clock is not required, making it possible to realize high-accuracy conversion. Furthermore, the clock frequency can be lowered, making it possible to reduce the power consumption.

While in the present embodiment, each ΔΣ modulator cascade-connected is a first-order modulator having a single integrator, an nth-order modulator where n integrators are connected may be used as each ΔΣ modulator.

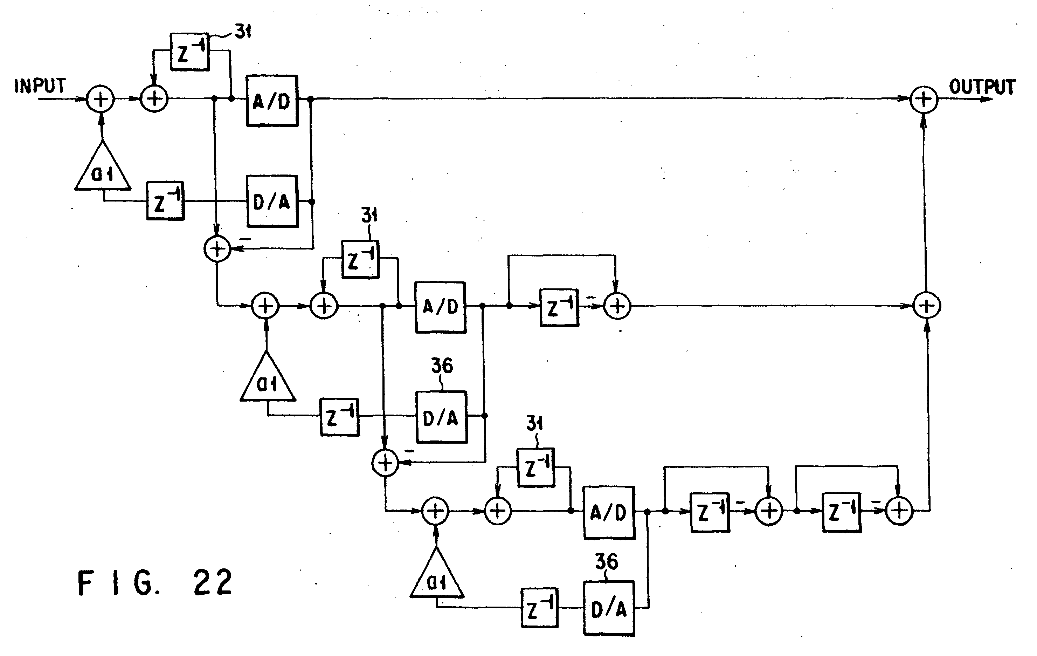

A tenth embodiment where the present invention is applied to an internal D/A converter in a ΔΣ modulation A/D converter will be explained with reference to FIG. 20.

When multi-bit converters are used as the internal A/D and D/A converters in the ΔΣ modulation D/A converter, making the data length at the A/D and D/A converter 1 bit longer enables the S/N ratio to be improved by 6 dB. However, the noise generated at the internal D/A converter appears directly at the output. When a multi-bit converter was used as an internal D/A converter in a conventional ΔΣ modulation D/A converter, the conversion accuracy of the internal converter was lower than the generally expected conversion accuracy, with the result that the overall conversion accuracy was determined by the accuracy of the internal D/A converter and consequently a high conversion accuracy could not be realized. Furthermore, to realize a high conversion accuracy, trimming was needed, leading to a rise in the cost.

When a D/A converter using a selection device of the invention is used as the internal D/A converter in the ΔΣ modulation D/A converter, the effect of the accuracy of the elements (e.g., current cells) constituting the internal D/A converter is reduced remarkably in the vicinity of DC. Therefore, use of the present invention makes it possible to improve the overall conversion accuracy even if a process with a low element accuracy is used.

Furthermore, although a third-order or higher ΔΣ modulator is generally unstable in operation, use of multi-bit converters for the internal A/D and D/A converters enables the modulator to operate stably. If the order of the ΔΣ modulator can be raised, the over-sampling ratio can be lowered, making it unnecessary to use high-speed elements. When the modulator is operated at the same over-sampling ratio, much higher-accuracy conversion can be realized.

As shown in FIG. 20, the output of the internal D/A converter 36 is connected to the inputs of the integrators $31_1$ and $31_2$. Since in the ΔΣ modulator, the effect of errors in the D/A converter 36 is the greatest in the first stage, only applying a D/A converter using a selection device of the invention to D/A conversion at the first stage can produce a great effect.

Although the ΔΣ modulator having a zero point on DC has been explained, when the ΔΣ modulator and the selection device of the invention are of the band-pass type, a band-pass D/A converter, or a band-pass converter that improves the conversion accuracy at an arbitrary frequency, can be realized.

For instance, an example useful for understanding the invention, where a zero point is placed at fs/4 to improve the accuracy at fs/4 is shown in FIG. 21. A D/A converter 36 using the band-pass selection device shown in FIG. 13 is used as the internal D/A converter in the band-pass ΔΣ modulator shown in FIG. 21.

Furthermore, in the embodiment shown in FIG. 20, the input to the selection device, or the input to the internal D/A converter, is the output of the ΔΣ modulator. Therefore, even when DC is supplied as an input signal, the input to the selection device is a signal subjected to ΔΣ modulation. Furthermore, use of a multi-bit converter as the D/A converter in the ΔΣ modulator enables the concentration of noise components to be reduced in the modulator. Therefore, although direct input of a DC signal to the selection device of the invention causes the disadvantage that noise components concentrate on a specific frequency, the present embodiment can reduce the effect of noise concentration.

An embodiment where the present invention is applied to an internal D/A converter in a cascade ΔΣ modulation A/D converter will be explained with reference to FIG. 22.

The cascade ΔΣ modulator is a high-order modulator where ΔΣ modulators are cascade-connected. A third-order or higher modulator of this type operates stably and is also known as the MASH-type modulator.

The MASH type has the disadvantage that since quantization noises mixed in the individual $\Delta\Sigma$ modulators are canceled digitally, the difference between the transfer characteristic of each $\Delta\Sigma$ modulator and the ideal values appears directly as cancel errors and consequently the requirements for element accuracy is severe.

Therefore, using a multi-bit internal A/D and D/A converters in each stage enables quantization noise itself to be reduced, thereby decreasing the effect of the cancel error.

Accordingly, use of a D/A converter using a selection device of the invention remarkably reduces the effect of the accuracy of the elements (e.g., current cells) constituting the internal D/A converter in the vicinity of DC, so that a high-accuracy converter can be realized.

Because the effect of the cancel error in the second stage and later is reduced by noise shaping, it is less than the effect in the first stage. For this reason, only using the internal D/A converter of the invention in the first stage can also produce a great effect.

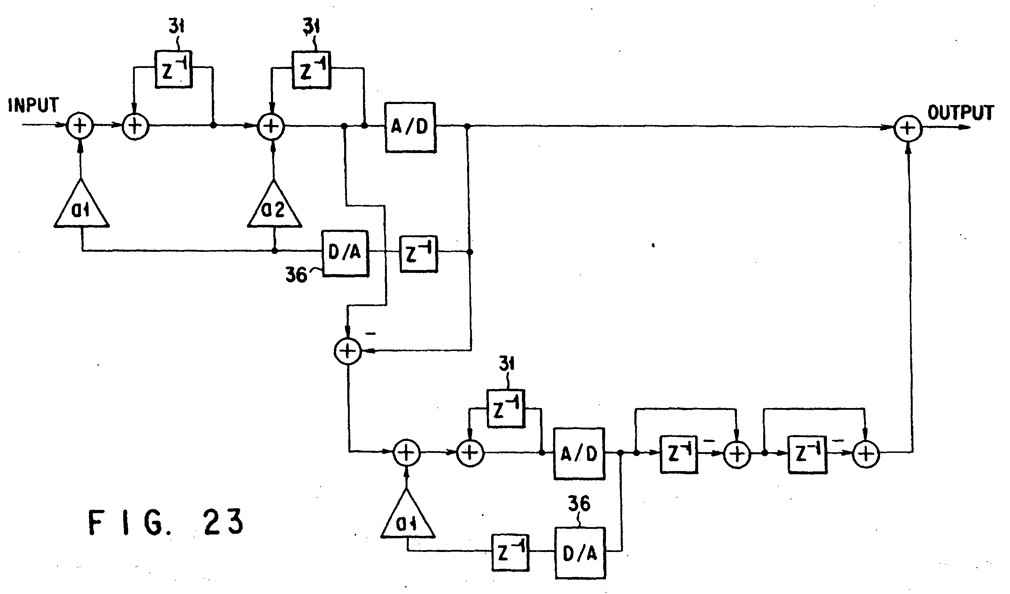

A twelfth embodiment of the present invention will be explained with reference to FIG. 23.

A method of reducing cancel error in the first stage is to make the $\Delta\Sigma$ modulator in the first stage of the second order or higher. For instance, in the case of the second order, the effect of the difference between the transfer characteristic of the first stage and the ideal values on cancel error undergoes the first-order noise shaping. Therefore, the effect of element accuracy can be reduced.

Furthermore, use of a D/A converter using a selection device of the invention remarkably reduces the effect of the accuracy of the elements (e.g., current cells) constituting the internal D/A converter in the vicinity of DC, so that a higher-accuracy converter can be realized.

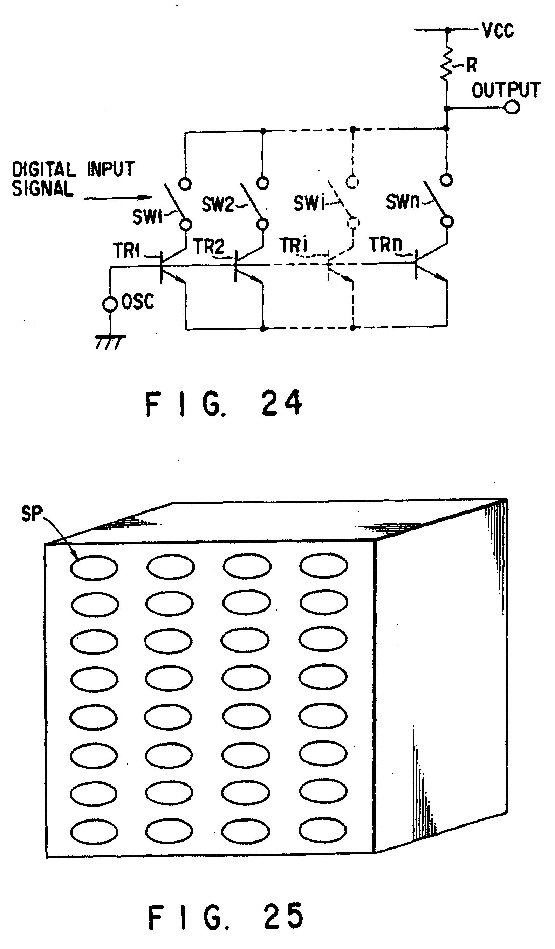

FIG. 24 shows a thirteenth embodiment where the present invention is applied to an amplitude modulator.

In this embodiment, the output terminal of a carrier wave oscillator (OSC) is connected to the base terminals of transistors $TR_l$ to $TR_n$ connected in parallel with each other and a resistor R connected to the collector terminals produces a voltage output. Switches $SW_1$ to $SW_2$ are inserted between the resistor R and the transistors $TR_l$ to $TR_n$. Controlling the switches according to the switch signal input changes the amplitude of the carrier wave, thereby producing the amplitude-modulated output. Using a selection device of the invention for control of the switches alleviates the effect of errors stemming from the imperfectness of the individual transistors and switches, making it possible to realize a high-accuracy modulator.

Furthermore, since use of a rectangular wave as a carrier wave enables the transistors to function as switches, the modulator can be composed of switches only, with the result that the effect of the non-linearity of the transistor can be minimized, making it possible to construct a higher-accuracy modulator. A fourteenth embodiment where the present invention is applied to a speaker system will be explained with reference to FIG. 25.

Many groups of speakers SP are arranged. The individual speakers SP are connected in place of D/A converters shown in the eighth embodiment, whereby the input signal in the eighth embodiment is converted into an audio signal. A selection device of the invention is used to select the speakers SP according to the input signal to the D/A converter and drives them by using a signal of 0 or a signal of 1 or -1. This enables the speakers to be driven only by the switches. Therefore, the deterioration resulting from the performance of the amplifier, which was found in conventional analog amplifiers, can be reduced.

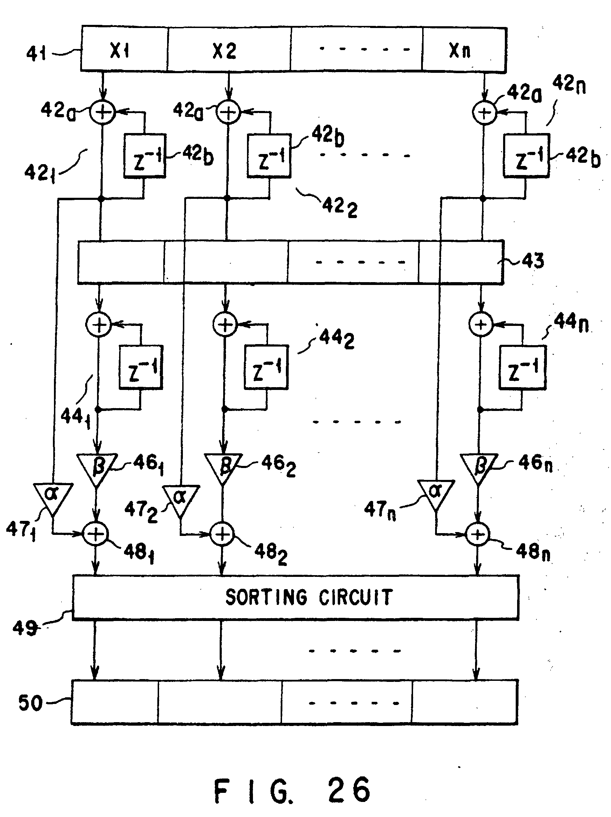

FIG. 26 shows a selection device according to a concrete example of the present invention. According to the selection device, a register 41 for holding a select signal including a plurality of signal components X1 to Xn is connected to an accumulator 43 via integrators each comprising an adder 42a and a delay element 42b. The register 43 holds an integration value of each of the selection signal components Xl to Xn. The output terminals of the register 43 are connected to the coefficient multipliers $46_l$ to $46_n$ via integrators $44_l$ to $44_n$, respectively. The output terminals of coefficient multipliers $46_l$ and the output terminals of coefficient multipliers $47_l$ to $47_n$ whose input terminals are connected to the integrators $42_l$ to $42_n$ are connected to adders $48_l$ to $48_n$, respectively. In other words, the coefficient multipliers $46_l$ to $46_n$ multiplies the integrated accumulation signals from the integrators $42_l$ to $42_n$ with coefficients $\beta$, respectively, and the coefficient multipliers $47_l$ to $47_n$ multiplies the integrated selection signals from the integrators $42_l$ to $42_n$ with coefficient $\alpha$. The output signals from the coefficient multipliers $46_l$ to $46_n$ and $47_l$ to $47_n$ are added by the adders $48_l$ to $48_n$, respectively. The addition result signals from the adders $48_l$ to $48_n$ are input to a sorting circuit 49. This sorting circuit 49 sorts the addition result signals in accordance with a descending order and permits the selection signal components corresponding to the used times of each current cell during a predetermined time period to hold in a register 50. The register 50 transfers the select signal having the selection signal components to the D/A converter and the register 41. At this time, the register 41 is updated to the new selection signal from the register 50.

There will now be described a transmitter provided with an internal D/A converter using the selection device of the present invention.

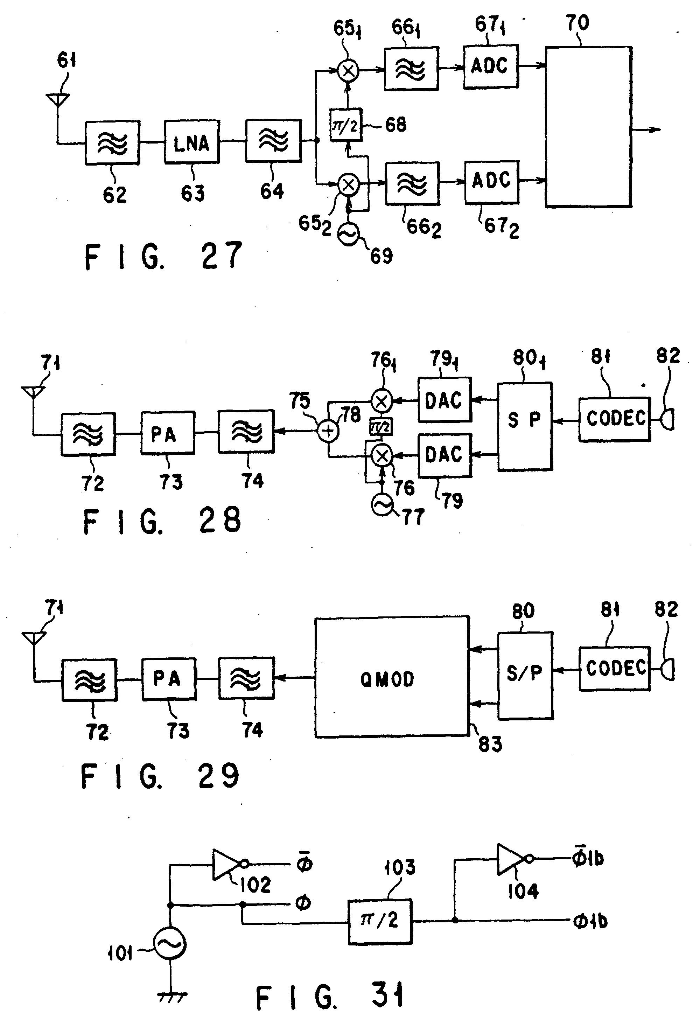

According to the transmitter shown in FIG. 27, the received signal input via an antenna 61 is input to a band-pass filter 62, whereby the signal outside the signal band is attenuated. The output signal from the bandpass filter is amplified by a low noise amplifier (LNA) 63 whose output signal is input to mixers $65_1$ and $65_2$ via a bandpass filter 64. In the mixers $65_1$ and $65_2$, the received signal is frequency-converted by the local frequency signal from the local oscillator 69 and the $\pi/2$ phase-shifted local frequency signal from a $\pi/2$ phase shifter 68. The frequency-converted received signals from the mixers $65_1$ and $65_2$ are input to lowpass filters $66_1$ and $66_2$, respectively, and subjected to a channel selection. The channel-selected received signals are input to A/D converters (ADC) $67_1$ and $67_2$, respectively, to be converted to digital signals. The digital signals from A/D converters $67_1$ and $67_2$ are input to a demodulator 70 to be demodulated.

The A/D converters $67_1$ and $67_2$ each comprises a $\Delta\Sigma$ type A/D converter having two stage integrators $31_1$ and $31_2$ and an internal D/A converter 36 in which the selection device of the present invention shown in FIG. 20 is used. In this embodiment, a multi-bit D/A converter is used as the internal D/A converter in order to expand the dynamic range of the A/D converter. When the multi-bit D/A converter is used, the non-linearity of the D/A converter 36 determines the A/D conversion characteristic of the whole of the A/D converter shown in FIG. 20. Therefore, the internal D/A converter 36 need high accuracy. In this embodiment, the D/A conversion circuit of the D/A converter 36 has a circuit having switches selectively controlled by the selection device shown in FIGS. 1 and 2, as shown in FIGS. 3 and 4. In the conversion circuit of FIG. 3, the current cells $22_l$ to $22_n$ are selected by the selection device so that the number of the selected current cells is determined by the input signal. In this case, the addition signal larger or smaller than the input reference signal in level is selected from among the addition signals from the adder 18, so that the current cells $22_l$ to $22_n$ are uniformly selected in accordance with the selected addition signal. Accordingly, the noise produced due to the variations of the elements in the specific frequency band can be decreased.

As described above, when the selection device shown in FIGS. 1 and 2 is used in the internal D/A converter of the A/D converter, a high accuracy A/D converter is realized even if the elements constructing the internal D/A converter are not uniform in characteristics. Accordingly, the A/D converter having a wide dynamic range is obtained in easy, so that no automatic gain controller (AGC) is required and thus the cost is reduced. If the A/D converter utilizing the present invention provides no desired dynamic range, an AGC may be connected to the pre-stage of the A/D converter. In this case, since the dynamic range of the A/D converter is largely expanded, the variable gain width of the AGC may be small.

In the embodiment, since the lowpass filters $66_1$ and $66_2$ are used for channel selection, a sharp cut-off characteristic is required for the lowpass filters. Since the A/D converter 67, however, can have a wide dynamic range, it can A/D-convert a wide-band signal and thus the lowpass filters $66_1$ and $66_2$ can comprise an anti-aliasing filter having a gentle cut-off characteristic and the channel selection can be performed by the digital modulator 70.

Although the lowpass filters $66_1$ and $66_2$ are required to be lower in distortion, they can be constituted only by passive elements capable of being assembled in an IC device in a case of using a gentle cut-off characteristic filter. For this reason, the low-distortion lowpass filter can be easily realized.

FIG. 28 shows a transmitter applying the present invention. According to the transmitter, the input speech signal from a sound source, e.g., microphone 82 is digitally coded by a code 81, and mapped to I and Q quadrature signals by a serial-to-parallel converter 80. The I and Q quadrature signals are converted to analog signals by D/A converters (DAC) $79_1$ and $79_2$. The analog signals are quadrature-modulated by a quadrature modulator comprising an adder 75, multipliers $76_1$, $76_2$, a local oscillator 77 and $\pi/2$ phase shifter 78. The quadrature-modulated signal is passed through a bandpass filter 74 so that undesired frequency signal components are attenuated, and then are amplified by a power amplifier (PA) 73 and input to a bandpass filter 72. The amplified signal is passed through a bandpass filter 72 so that undesired frequency components are attenuated and then transmitted via an antenna 71.

The transmitter includes the D/A converters $79_1$ and $79_2$ each comprising the selection device shown in FIGS. 1 and 2 and the D/A conversion circuit shown in FIGS. 3 and 4. Accordingly, even if the D/A converters $79_1$ and $79_2$ are constructed by elements which are not uniform in characteristics, the transmitter having good modulation accuracy is realized.

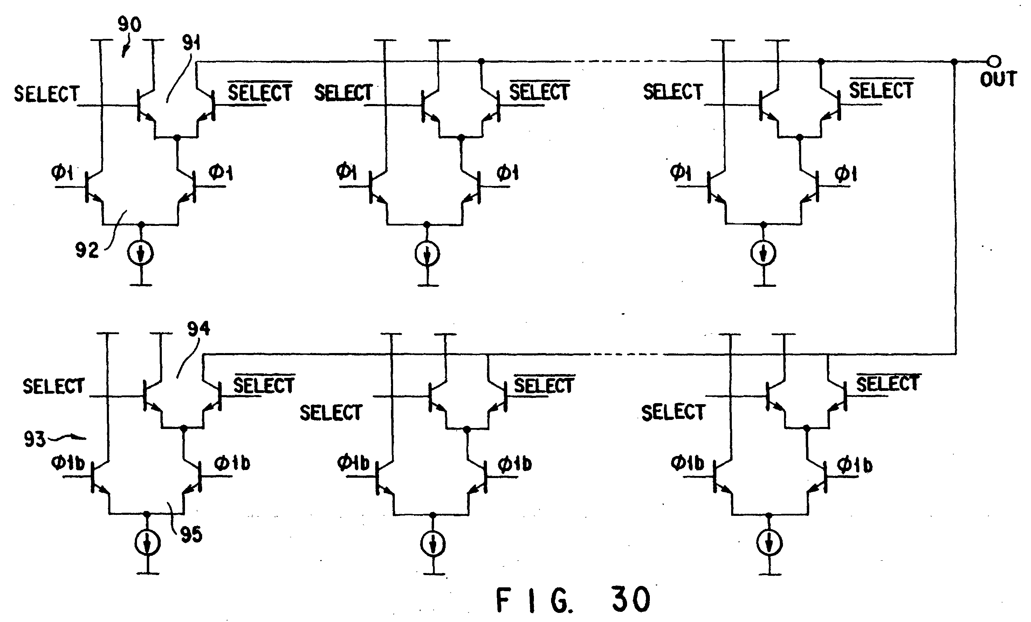

FIG. 29 shows a transmitter using a quadrature modulator (QMOD) 83 constructed as shown in FIG. 30. That is, the quadrature modulator 83 comprises a plurality of transistor circuits 90 and 93 connected to an output terminal OUT. The transistor circuit 90 comprises a pair of transistors 91 having emitters connected to each other and a pair of transistors 92 having emitters connected to each other, the collector of one of the transistors 92 being connected to the emitters of the transistors 91. The transistor circuit 93 comprises a pair of transistors 94 having emitters connected to each other and a pair of transistors 95 having emitters connected to each other, the collector of one of the transistors 95 being connected to the emitters of the transistors 94.

In the above quadrature modulator 83, the bases of the transistors 91 and 94 are supplied with a select signal "select" and an inverse select signal "select" output from the select device shown in FIGS. 1 and 2. The bases of the transistors 92 and 95 are supplied with local frequency signals $\phi$, $\bar{\phi}$ and $\phi 1b$, $\bar{\phi} 1b$. If the select signals are input to the bases of the transistors 91 and 94 and the local frequency signals are supplied to the bases of the transistors 92 and 95, the current cells Ii are selected. As a result, the amplitude of the output signal is modulated in accordance with the number of selected cells.

FIG. 31 shows a signal generator for generating the local frequency signals $\phi$, $\bar{\phi}$ and $\phi 1b$, $\bar{\phi} 1b$. The signal

generator comprises an local oscillator 101 for generating a local frequency signal $\phi$, an inverter for inverting the local frequency signal $\phi$ to output the inverted local frequency signal $\bar{\phi}$, a $\pi/2$ phase shifter 103 for phase-shifting the local frequency signal $\phi$ by $\pi/2$ to output the signal $\phi 1b$, and an inverter for inverting the signal $\phi 1b$ to output the inverted signal $\phi 1b$.

As described above, the transistors 95 are supplied with the $\pi/2$-shifted local frequency signal, so that an amplitude-modulated current output is obtained at the output terminal OUT. If a voltage output is required, it is obtained by connecting a resistor to the output terminal OUT.

In the embodiment, the amplitude of the output signal is determined by the number of current cells selected by the select signal "select" which is generated by the selection device shown in FIGS. 1 and 2. Therefore, it is suppressed in specific frequency band similarly to the receiver that the operation of the transmitter is influenced by the error based on the transistor size. For this reason, even if the elements of poor accuracy are used in the quadrature modulator, the digital conversion and frequency conversion can be performed with good accuracy. Accordingly, the high accuracy D/A converter and quadrature modulator which are required in conventional transmitters are not required in the present transmitter. Furthermore, processes using high accuracy elements are not required, so that cost is decreased.

As described above, use of the invention can reduce the effect of the analog element accuracy on the conversion accuracy, making it possible to achieve high-accuracy conversion without increasing the operation speed. Because the accuracy of element need not be high, an expensive process or trimming is not required, enabling cost reduction and miniaturization. Furthermore, the decrease of the operation speed makes the power consumption lower.

**Claims**

1. A selection device comprising selector means for selecting selectable objects in accordance with an input signal level, that said selection device includes:

    integrating means ($14_1$, $14_2$) for integrating, one or more times, data representing a state in which each of selectable objects ($22_I...22_n$) having a relative error between them is used during a predetermined period; and **characterized in that**

    said selector means (13) includes:

    comparing means (19) for comparing a signal corresponding to an integration result of the integrating means with a previous signal corresponding to a previous integration result to output a comparison result representing the number of times the selectable objects are used; and
    selection means (20) for selecting the selectable objects in an order in which the number of times the selectable objects are used during the predetermined period descends in accordance with the comparison result.

2. The selection device according to claim 1, **characterized in that** the integrating means comprises a first integrator ($14_1$) for integrating a select signal from the selector means (13) and a second integrator ($14_2$) for integrating the integral signal of the first integrator, and the selection device further comprises first and second multipliers (16, 17) for multiplying the integral output signals of the first and second integrators by specific coefficients, respectively, and an adder (18) for adding the output signals of the first and second multipliers (16, 17), and the comparing means (19) compares the addition signal of the adder with a previous addition signal to output the comparison result.

3. The selection device according to claim 1, **characterized in that** the integrating means comprises a single integrator (14) for integrating the select signal of the selector means (13) and supplying an integration output signal to the selection means.

4. The selection device according to claim 1, **characterized in that** the integrating means comprises first, second and third integrators ($14_1$, $14_2$, $14_3$) connected at three stages for integrating the select signal of the selector means (13), the integration signal of the third integrator ($14_3$) being supplied to the comparing means.

5. A selection device according to claim 1 **characterized by** an adder (29) for adding a dither signal to the input signal, the selection means (20) selecting the selectable objects in accordance with the integration result of the integrating means and an addition result of the adder.

**Patentansprüche**

1. Auswahlvorrichtung mit Selektormitteln zum Auswählen auswählbarer Objekte in Übereinstimmung mit einem Eingangssignalpegel, wobei die Auswahlvorrichtung umfasst:

   Integrationsmittel ($14_1$, $14_2$) zum einmaligen oder wiederholten Integrieren von Daten, die einen Zustand darstellen, bei dem jedes der auswählbaren Objekte ($22_I$, ... $22_n$), die einen relativen Fehler zwischen ihnen aufweisen, während einer vorbestimmten Zeitspanne verwendet wurde; und

   **dadurch gekennzeichnet, dass** das Selektormittel (13) umfasst:

   Vergleichsmittel (19) zum Vergleichen eines Signals, das einem Integrationsergebnis des Integrationsmittels entspricht, mit einem vorherigen Signal, das einem vorherigen Integrationsergebnis entspricht, um ein Vergleichsergebnis auszugeben, das die Anzahl von Malen darstellt, die die auswählbaren Objekte verwendet wurden, und
   Auswahlmittel (20) zum Auswählen der auswählbaren Objekte in einer Reihenfolge, in der die Anzahl von Malen, die die auswählbaren Objekte während der vorbestimmten Zeitspanne verwendet wurden, in Übereinstimmung mit den Vergleichsergebnis abfällt.

2. Auswahlvorrichtung gemäß Anspruch 1, **dadurch gekennzeichnet, dass** das Integrationsmittel einen ersten Integrator ($14_1$) zum Integrieren eines Auswahlsignals von dem Selektormittel (13) und einem zweiten Integrator ($14_2$) zum Integrieren des Integralsignals des ersten Integrators umfasst, und die Auswahlvorrichtung ferner erste und zweite Multiplizierer (16, 17) zum Multiplizieren der Integral-Ausgangssignale der ersten bzw. zweiten Integratoren mit spezifischen Koeffizienten, und einen Addierer (18) zum Addieren der Ausgangssignale der ersten und zweiten Multiplizierer (16, 17) umfasst, und wobei das Vergleichsmittel (19) das Additionssignal des Addierers mit einem vorherigen Additionssignal vergleicht, um das Vergleichsergebnis auszugeben.

3. Auswahlvorrichtung gemäß Anspruch 1, **dadurch gekennzeichnet, dass** das Integrationsmittel einen Einzelintegrator (14) zum Integrieren des Auswahlsignals des Selektormittels (13) und zum Liefern eines Integrationsausgangssignals an das Auswahlmittel umfasst.

4. Auswahlvorrichtung gemäß Anspruch 1, **dadurch gekennzeichnet, dass** das Integrationsmittel erste, zweite und dritte Integratoren ($14_1$, $14_2$, $14_3$) umfasst, die in drei Stufen zum Integrieren des Auswahlsignals des Selektormittels (13) verbunden sind, wobei das Integrationssignal des dritten Integrators ($14_3$) an das Vergleichsmittel geliefert wird.

5. Auswahlvorrichtung gemäß Anspruch 1, **gekennzeichnet durch** einen Addierer (29) zum Addieren eines Dither-Signals zu dem Eingangssignal, wobei das Auswahlmittel (20) die auswählbaren Objekte in Übereinstimmung mit dem Integrationsergebnis des Integrationsmittels und eines Additionsergebnisses des Addierers auswählt.

**Revendications**

1. Dispositif de sélection comprenant un moyen de sélecteur pour sélectionner des objets sélectionnables conformément à un niveau de signal d'entrée, ledit dispositif de sélection incluant:

   un moyen d'intégration ($14_1$, $14_2$) pour intégrer, une ou plusieurs fois, des données qui représentent un état dans lequel chacun des objets sélectionnables ($22_I$ ... $22_n$) présentant une erreur relative entre eux est utilisé pendant une période prédéterminée; et
   **caractérisé en ce que**:
   ledit moyen de sélecteur (13) inclut:

   un moyen de comparaison (19) pour comparer un signal qui correspond à un résultat d'intégration du moyen d'intégration à un signal précédent qui correspond à un résultat d'intégration précédent afin d'émettre en sortie un résultat de comparaison qui représente le nombre de fois que les objets sélectionnables sont utilisés; et
   un moyen de sélection (20) pour sélectionner les objets sélectionnables selon un ordre selon lequel le nombre de fois que les objets sélectionnables sont utilisés pendant la période prédéterminée diminue conformément au résultat de comparaison.

2. Dispositif de sélection selon la revendication 1, **caractérisé en ce que** le moyen d'intégration comprend un premier intégrateur ($14_1$) pour intégrer un signal de sélection en provenance du moyen de sélecteur (13) et un second intégrateur ($14_2$) pour intégrer le signal d'intégrale du premier intégrateur, et le dispositif de sélection comprend en outre des premier et second multiplicateurs (16, 17) pour multiplier les signaux de sortie d'intégrale des premier et second intégrateurs par des coefficients spécifiques, de façon respective, et un additionneur (18) pour additionner les signaux de sortie des premier et second multiplicateurs (16, 17), et le moyen de comparaison (19) compare le signal d'addition de l'additionneur à un signal d'addition précédent afin d'émettre en sortie le résultat de comparaison.

3. Dispositif de sélection selon la revendication 1, **caractérisé en ce que** le moyen d'intégration comprend un unique intégrateur (14) pour intégrer le signal de sélection du moyen de sélecteur (13) et pour appliquer un signal de sortie d'intégration sur le moyen de sélection.

4. Dispositif de sélection selon la revendication 1, **caractérisé en ce que** le moyen d'intégration comprend des premier, second et troisième intégrateurs ($14_1$, $14_2$, $14_3$) qui sont connectés au niveau de trois étages pour intégrer le signal de sélection du moyen de sélecteur (13), le signal d'intégration du troisième intégrateur ($14_3$) étant appliqué sur le moyen de comparaison.

5. Dispositif de sélection selon la revendication 1, **caractérisé par** un additionneur (29) pour additionner un signal de tremblement au signal d'entrée, le moyen de sélection (20) sélectionnant les objets sélectionnables conformément au résultat d'intégration du moyen d'intégration et à un résultat d'addition de l'additionneur.

INPUT ○——— SELECTOR ———————————————————————————— ○ SELECTION SIGNAL

INTEGRATOR ←——— INTEGRATOR

F I G. 1

INTEGRATOR ←———————————————— INTEGRATOR

MULTIPLIER 17        MULTIPLIER 16

⊕ 18

INPUT ——→ COMPARATOR 19

INPUT ——→ SELECTOR 20

F I G. 2

○ IO

SELECTION SIGNAL ——→

I1    I2    Ii    In

F I G. 3

F I G. 4

F I G. 5

F I G. 6

F I G. 7

F I G. 9

F I G. 10

F I G. 8

EP 0 704 978 B1

F I G. 11

F I G. 12

F I G. 13

18

F I G. 14

F I G. 15

F I G. 16

F I G. 17

FIG. 18

FIG. 20

FIG. 21

F I G. 19

F I G. 22

F I G. 23

EP 0 704 978 B1

F I G. 24

F I G. 25

F I G. 26

F I G. 27

F I G. 28

F I G. 29

F I G. 31

FIG. 30

EP 0 704 978 B1